# EUROPEAN PATENT APPLICATION

(11) **EP 4 332 697 A1**
(43) Date of publication of application: **06.03.2024**
(21) Application number: 23187245.8
(22) Date of filing: 24.07.2023
(51) Int. Cl.: G05B 17/02

(54) **SYSTEM AND METHODS FOR MODELING CAPABILITIES WITHIN SYSTEM MODELS OF INDUSTRIAL SYSTEMS**

(30) Priority: 01.09.2022 US 202217901828
(71) Applicant: Rockwell Automation Technologies, Inc., Mayfield Heights OH 44124 (US)
(72) Inventor: Geer II, James M., Mayfield Heights, OH, 44124 (US); Majewski, Lorenzo P., Mayfield Heights, OH, 44124 (US); Stanek, Christopher E., Mayfield Heights, OH, 44124 (US); D'Mura, Paul R., Mayfield Heights, OH, 44124 (US)
(74) Representative: Grünecker Patent- und Rechtsanwälte PartG mbB

(57) **Abstract**

Systems and methods for modeling capabilities within system models of industrial systems. One system includes an electronic processor configured to receive a request for a system model of an industrial system associated with a set of components. The electronic processor is also configured to access system data associated with the industrial system. The electronic processor is also configured to generate, based on at least the system data, a system model such that the system model includes a set of capabilities associated with the industrial system, wherein each capability included in the set of capabilities is associated with a function of the industrial system. The electronic processor is also configured to enable transmission of the system model for display.

## Description

### CROSS-REFERENCE TO RELATED APPLICATIONS

Not applicable.

### BACKGROUND INFORMATION

A system model generally refers to a representation of components (and associated relationships) of an industrial system. A system model may be used as a tool to conceptualize and construct industrial systems. Accordingly, a system model may be considered as the foundation of an industrial system.

However, an end-user's industrial system is likely an amalgamation of "best in class" or "closest compromise" products from different industrial system vendors. Thus, the system model may include various combinations of different (a) control types (e.g., continuous, discrete, and batch), (b) automated processes and manual processes, and (c) application specifications unique to the end-user's implementation of the industrial system. These differences may impede naturally modeling an industrial system (e.g., the whole plant floor of an end-user). This may be problematic. The result may be that the foundation upon which the industrial system is built (e.g., the system model) is awkward and, ultimately, complicates numerous aspects of the industrial system, including, e.g., configuration and implementation of the industrial system. As a result, end-users are generally constrained by the limitations of the system model they use.

### SUMMARY

The following presents a simplified summary of the disclosed technology herein in order to provide a basic understanding of some aspects of the disclosed technology. This summary is not an extensive overview of the disclosed technology. It is intended neither to identify key or critical elements of the disclosed technology nor to delineate the scope of the disclosed technology. Its sole purpose is to present some concepts of the disclosed technology in a simplified form as a prelude to the more detailed description that is presented later.

The technology disclosed herein relates generally to industrial systems, and, more particularly, to modeling capabilities within system models of industrial systems.

Embodiments described herein may leverage the abstract concept of objects when referring to components of an industrial system, such that users may construct capabilities (e.g., sets of objects that together follow a set of rules) that may then be implemented within a system model. The set of rules govern construction but also may be used to enforce the validity of the system model. This general method may be of great value for, e.g., building capabilities to support manufacturing standards, industry-specific solutions, customized systems for individual end-users, and the like. As such, embodiments described herein allow end-users a much greater degree of influence over modeling their factory as they operate it.

Generally, a system model is a set of components with relationships, where the system model describes or represents an end-user's configuration of an industrial system (e.g., an end-user's factory or plant as a whole). As used herein, a "component" may include an industrial device (e.g., a conveyor belt, a pump, or the like), an industrial process (e.g., a recipe or the like), an industrial concept (e.g., a work shift or the like), or a combination thereof. The system model may be associated with system metadata (or system "grammar"). The system metadata may be a description of the set of components and their inter-relationships that provide a set of rules for configuring an industrial system (e.g., an end-user's configuration of a factory or plant). In some embodiments, a capability is a specialization that exists within a system model. Thus, a capability is a set of components with special relationships governing how the components interact with each other.

In some embodiments, a system model may be implemented as an object-based system model such that each industrial asset (e.g., each component or device included in an industrial system) may be associated with an object definition. Accordingly, in some embodiments, the system model of an industrial system includes a plurality of objects (or "SmartObjects"), where each object represents an industrial asset of the industrial system. In some embodiments, the system model, via the implementation of objects, may use object inheritance features to propagate changes made to an object definition to all instances of the associated object used throughout a system model. A SmartObject may be an abstraction for a manufacturing entity. As used herein, a SmartObject (or object) may represent a component (physical or conceptual) or device with internal intelligence (e.g., such that the component or device may operate, at least to some extent, interactively and autonomously), such as a smart component or device. A system model may be considered a first capability, a set of SmartObjects that are related to each other by containment (e.g., this production line contains these pieces of equipment) and by grouping (e.g., those storage tanks are all part of a tank farm). A capability then is a configured set of SmartObjects that together follow a set of rules to implement a specific capability. The SmartObjects of a capability only pay attention to other SmartObjects of that capability when applying relationship rules, so the SmartObject may be part of many capabilities without affecting its membership. This allows the system model to host multiple capabilities and a SmartObj ect to be a member of many capabilities.

Accordingly, embodiments described herein provide systems and methods for modeling different manufacturing capabilities within a system model by describing sets of components and the relationships between them and enforcing those relationships. One embodiment provides a system for modeling capabilities within system models of industrial systems. The system includes an electronic processor configured to receive a request for a system model of an industrial system associated with a set of components. The electronic processor is also configured to access system data associated with the industrial system. The electronic processor is also configured to generate, based on at least the system data, a system model such that the system model includes a set of capabilities associated with the industrial system, wherein each capability included in the set of capabilities is associated with a function of the industrial system. The electronic processor is also configured to enable transmission of the system model for display.

Another embodiment provides a method for modeling capabilities within system models of industrial systems. The method includes receiving, with an electronic processor, a request for a system model of an industrial system associated with a set of components. The method also includes accessing, with the electronic processor, system data associated with the industrial system. The method also includes generating, with the electronic processor, based on at least the system data, a system model such that the system model includes a set of capabilities associated with the industrial system, wherein each capability included in the set of capabilities is associated with a function of the industrial system. The method also includes enabling, with the electronic processor, transmission of the system model for display.

Yet another embodiment provides a non-transitory computer-readable medium storing instructions that, when executed by an electronic processor, perform a set of functions. The set of functions include receiving a request for a system model of an industrial system associated with a set of components. The set of functions also includes accessing system data associated with the industrial system. The set of functions also includes generating based on at least the system data, a system model such that the system model includes a set of capabilities associated with the industrial system, wherein each capability included in the set of capabilities is associated with a function of the industrial system. The set of functions also includes enabling transmission of the system model for display.

The foregoing and other aspects and advantages of the present disclosure will appear from the following description. In the description, reference is made to the accompanying drawings which form a part hereof, and in which there is shown by way of illustrations one or more embodiments of the present disclosure. Such embodiments do not necessarily represent the full scope of the present disclosure, however, and reference is made therefore to the claims and herein for interpreting the scope of the present disclosure.

### BRIEF DESCRIPTION OF DRAWINGS

The present disclosure will be better understood and features, aspects and advantages other than those set forth above will become apparent when consideration is given to the following detailed description thereof. Such detailed description makes reference to the following drawings.
FIG. 1 schematically illustrates a system for modeling capabilities within system models of industrial systems in accordance with some embodiments.
FIG. 2 illustrates a user device of the system of FIG. 1 according to some embodiments.
FIG. 3 schematically illustrates an example system model for an industrial system implemented using batch control according to some embodiments.
FIG. 4 schematically illustrates an example system model for an industrial system implemented using discreate manufacturing routes according to some embodiments.
FIG. 5 is a flowchart illustrating a method for modeling capabilities within system models of industrial systems using the system of FIG. 1 in accordance with some embodiments.
FIGS. 6-8 illustrate an example system model according to some embodiments.

### DETAILED DESCRIPTION

As utilized herein, terms "component," "system," "controller," "device," "manager," and variants thereof are intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a server and the server may be a component. One or more components may reside within a process and/or thread of execution and a component may be localized on one computer and/or distributed between two or more computers.

The disclosed technology is described with reference to the drawings, wherein like reference numerals are used to refer to like elements throughout. In the following description, for purposes of explanation, numerous specific details are set forth in order to provide a thorough understanding of the disclosed technology. It may be evident, however, that the disclosed technology may be practiced without these specific details. In other instances, well-known structures and devices are shown in block diagram form in order to facilitate describing the disclosed technology.

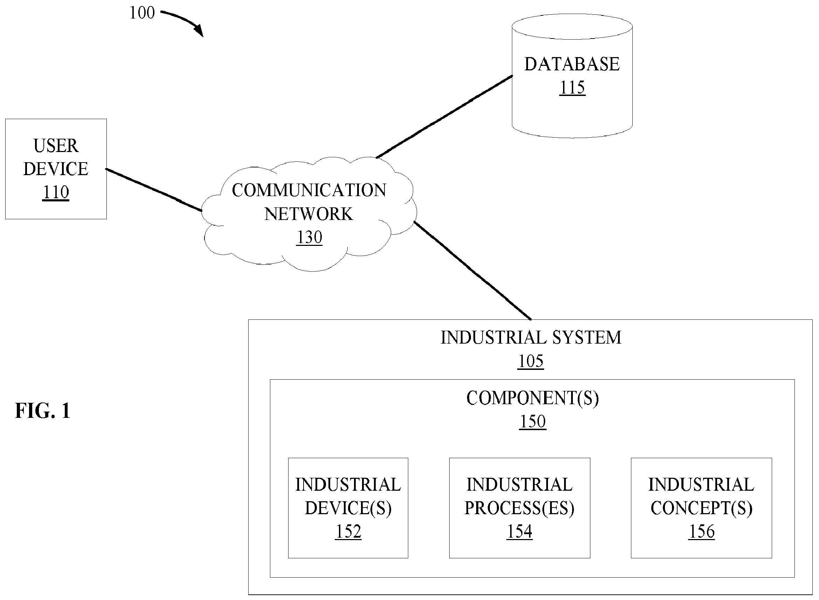

FIG. 1 schematically illustrates a system 100 for modeling capabilities within system models of industrial systems according to some embodiments. In the illustrated example, the system 100 may include an industrial system 105, a user device 110, and a database 115. In some embodiments, the system 100 includes fewer, additional, or different components in different configurations than illustrated in FIG. 1. As one non-limiting example, the system 100 may include multiple industrial systems 105, multiple user devices 110, multiple databases 115, or a combination thereof. As another non-limiting example, one or more components of the system 100 may be combined into a single device, such as, e.g., the user device 110 and the database 115. Alternatively, or in addition, in some embodiments, the user device 110, the database 115, or a combination thereof may be included as part of the industrial system 105 (e.g., as a component of the industrial system 105).

The industrial system 105, the user device 110, and the database 115 may communicate over one or more wired or wireless communication networks 130. Portions of the communication networks 130 may be implemented using a wide area network, such as the Internet, a local area network, such as a BLUETOOTH^{®} or WI-FI^{®}, and combinations or derivatives thereof. Alternatively, or in addition, in some embodiments, components of the system 100 may communicate directly as compared to through the communication network 130. Also, in some embodiments, the components of the system 100 may communicate through one or more intermediary devices not illustrated in FIG. 1.

The industrial system 105 may be a manufacturing system, such as, e.g., an industrial automation system or the like. The industrial system 105 may be configured to perform one or more industrial processes, manufacturing processes, production processes, or the like. In some embodiments, the industrial system 105 may perform a production method that produces goods or products. As one non-limiting example, the industrial system 105 may perform a vehicle manufacturing processor to assemble or produce a vehicle (or various components thereof). As another non-limiting example, the industrial system 105 may perform a food manufacturing process for making a food product.

In the illustrated example, the industrial system 105 may include one or more components 150. A component 150 may include an industrial device 152, an industrial process 154, an industrial concept 156, or another industrial asset of the industrial system 105.

An industrial device 152 may be a physical piece of equipment included in the industrial system 105. For example, an industrial device 152 may include a pump, a press, a conveyor, a valve, an industrial controller (e.g., a programmable logic controller ("PLC") and the like), a switch, a sensor, a server, a database, a human-machine interface ("HMI"), another piece of equipment that may be used in connection with an associated industrial process or application of the industrial system 105, or the like.

An industrial process 154 may be a procedure or method performed by the industrial system 105 (or a subset of industrial devices included therein). As one non-limiting example, an industrial process 154 may include a recipe for manufacturing a food product, such as chicken stock, chocolate ice cream, or the like.

An industrial concept 156 may be a concept associated with the industrial system 105, such as, e.g., a state associated with the industrial system 105, a capability associated with the industrial system 105, or the like. The concept (e.g., a state, a capability, or the like) may be associated with the industrial system 105 as a whole, one or more industrial devices 152 of the industrial system 105, one or more industrial processes 154 of the industrial system 105, or the like. As one non-limiting example, in some embodiments, the industrial concept 156 may be a state of an industrial device 152, such as, e.g., a clean state, an executing state, a resting state, or the like. As another non-limiting example, in some embodiments, the industrial concept 156 may be a capability of an industrial device 152, such as, e.g., a mixing capability, a storage capability, a heating capability, an assembly capability, or the like. As yet another non-limiting example, in some embodiments, the industrial concept 156 may be a state of an industrial process, such as a state of a recipe (e.g., a started state, a finished state, an in-progress state, or the like).

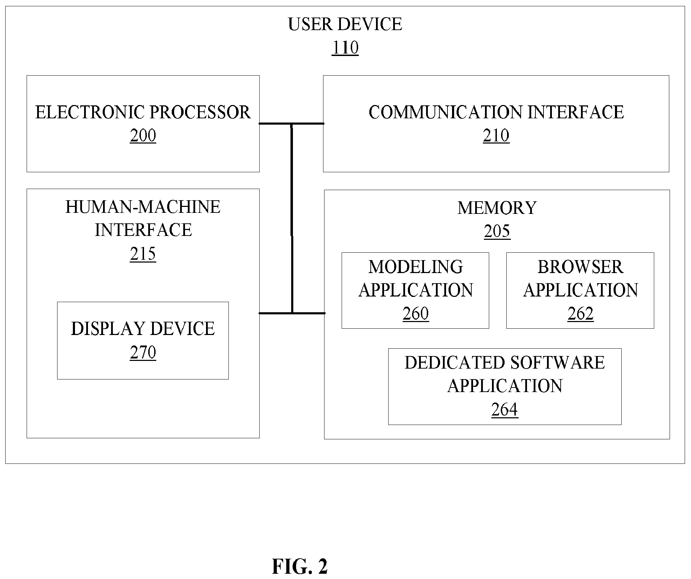

The user device 110 may be a computing device, such as a desktop computer, a laptop computer, a tablet computer, a terminal, a smart telephone, a smart television, a smart wearable, or another suitable computing device that interfaces with a user. As illustrated in FIG. 2, the user device 110 may include an electronic processor 200, a memory 205, a communication interface 210, and a HMI 215. The electronic processor 200, the memory 205, the communication interface 210, and the HMI 215 may communicate wirelessly, over one or more communication lines or buses, or a combination thereof. The user device 110 may include additional components than those illustrated in FIG. 2 in various configurations. The user device 110 may also perform additional functionality other than the functionality described herein. Also, the functionality (or a portion thereof) described herein as being performed by the user device 110 may be distributed among multiple devices (e.g., as part of a cloud service or cloud-computing environment), combined with another component of the system 100 (e.g., combined with the database 115, another component of the system 100, or the like), or a combination thereof.

The communication interface 210 may include a transceiver that communicates with the industrial system 105, the database 115, or a combination thereof over the communication network 130 and, optionally, one or more other communication networks or connections. In some embodiments, the communication interface 210 enables the user device 110 to communicate with the industrial system 105, the database 115, or a combination thereof over one or more wired or wireless connections. The electronic processor 200 may include a microprocessor, an application-specific integrated circuit ("ASIC"), or another suitable electronic device for processing data, and the memory 205 includes a non-transitory, computer-readable storage medium. The electronic processor 200 is configured to retrieve instructions and data from the memory 205 and execute the instructions.

As one non-limiting example, as illustrated in FIG. 2, the memory 205 may include a modeling application 260 (referred to herein as "the application 260"). The application 260 may be a software application executable by the electronic processor 200 in the example illustrated and as specifically discussed below, although a similarly purposed module may be implemented in other ways in other examples. The electronic processor 200 may execute the application 260 to facilitate system modeling, and, more specifically to facilitate modeling capabilities within system models of industrial systems (e.g., the industrial system 105). Alternatively, or in addition, the electronic processor 200 may execute the application 260 to facilitate the implementation of a modeled capability (e.g., by configuring the industrial system 105 based on a modeled capability such that the industrial system 105 functions according to the modeled capability).

A capability may include a set of components and relationships between those components that describe a function or functional portion associated with the industrial system 105. In some embodiments, a capability may be a default capability. A default capability may refer to a pre-existing or pre-established capability, such as, e.g., a capability established by a vendor or provider of the industrial system 105 (or a portion thereof). In some embodiments, a default capability includes pre-established or pre-existing objects and relationships of the system model, where the objects may be grouped together and can contain other objects. As one non-limiting example, when the industrial system 105 includes a mixer component (e.g., a physical piece of equipment that mixes one or more materials), the default capability of that mixer component may be a mixing capability or function. In some embodiments, a capability may be established by an industry (e.g., the automotive industry, the textile industry, a food industry, or the like), an industrial system providing entity (e.g., an industrial system provider, vendor, or manufacturer), or the like.

Alternatively, or in addition, a capability may be a custom capability. A custom capability may be defined by an end user. For example, in some embodiments, a system model may be extended by using one or more capabilities (as a custom capability). In some embodiments, when a user configures an object of a capability (e.g., a custom capability), that object follows the rules associated with that capability (i.e., type of object, type of relationship(s), and the like). A custom capability may be based on a specific user application or implementation of the industrial system 105. As one non-limiting example, a user may define a storage capability (as a custom capability) for the mixing component of the previous example, such that the mixing component performs a storage capability for one or more materials (as opposed to the default capability of mixing). Accordingly, a capability may be a user-defined or custom capability. As such, embodiments described herein enable an end-user to design and build capability models that fit their specific system specifications given a particular application or implementation of the industrial system 105 (e.g., by updating system metadata associated with the mixing component such that the system metadata includes a storage capability in addition to a mixing capability). Accordingly, in some embodiments, a capability is a specialization that exists within a system model (e.g., an existing system model for an end-user's current industrial system).

In some embodiments, a component 150 of the industrial system 105 may be associated with one or more capabilities. As one non-limiting example, following the previous example, the mixer component may be associated with a mixing capability (as a first capability) and a storage capability (as a second different capability). Accordingly, one or more of the components 150 of the industrial system 105 may be associated with multiple different capabilities.

As noted above, in some embodiments, a capability may include one or more relationships (also referred to herein collectively as "the relationship rules" and individually as "the relationship rule") provided by the associated set of components (e.g., one or more of the components 150). Accordingly, the relationship(s) may govern the functionality of the corresponding set of components 150 (such that the corresponding set of components perform the function associated with the capability). As such, in some instances the relationships may validate the system model.

In some embodiments, a relationship may be a containment relationship. A containment relationship may be used to described components 150 of the industrial system 105 that are contained together (e.g., are included within a process cell). As one non-limiting example, when the industrial system 105 performs an assembly process via three assembly stations, each assembly station has a containment relationship with the assembly line.

Alternatively, or in addition, in some embodiments, a relationship may be a grouping relationship. A grouping relationship may be used to describe components 150 of the industrial system 105 that share one or more common characteristics, such as, e.g., a state, a function, an associated capability, and the like. As one non-limiting example, when the industrial system 105 includes two storage components and three mixing components, the two storage components may have a grouping relationship with each other because each storage component provides a storage function while the three mixing components may have a grouping relationship with each other because each mixing component provides a mixing function. Accordingly, in some embodiments, the grouping relationships may enable an end-user to perform various searching functions, filtering functions, or the like (based on one or more common characteristics) with respect to the industrial system 150 (e.g., within the system model of the industrial system 105).

Alternatively, or in addition, in some embodiments, a relationship may be an application-specific relationship. An application-specific relationship may be a custom relationship defined by an end-user. A custom relationship may be based on a specific user application or implementation of the industrial system 105. As one non-limiting example, a custom relationship may allow a specific route or path between one or more industrial devices 152, such as, e.g., a conditional material transfer route or the like. An application-specific relationship may have a specific set of rules that govern the associated components. As one non-limiting example, when a user may have a recipe for producing an end-product, the components involved in producing the end-product (according to the recipe) may have an application-specific relationship.

As noted above, in some embodiments, the functionality (or a portion thereof) described herein as being performed by the user device 110 may be distributed among multiple devices (e.g., as part of a cloud service or cloud-computing environment). As one non-limiting example, in some embodiments, the system 100 may include a server (e.g., a computing device). The server may include similar components as the user device 110, such as an electronic processor (e.g., a microprocessor, an ASIC, or another suitable electronic device), a memory (e.g., a non-transitory, computer-readable storage medium), a communication interface, such as a transceiver, for communicating over the communication network 130 and, optionally, one or more additional communication networks or connections. Accordingly, in some embodiments, the server may store the application 260 as part of providing a system modeling and configuration service through the server. In such embodiments, to communicate with the server (e.g., interact with the application 260), the user device 110 may store a browser application 262 or a dedicated software application 264 executable by the user device electronic processor 200.

As noted above, the user device 110 may also include the HMI 215 for interacting with a user. The HMI 215 may include one or more input devices, one or more output devices, or a combination thereof. Accordingly, in some configurations, the HMI 215 allows a user to interact with (e.g., provide input to and receive output from) the user device 210. For example, the HMI 215 may include a keyboard, a cursor-control device (e.g., a mouse), a touch screen, a scroll ball, a mechanical button, a display device (e.g., a liquid crystal display ("LCD")), a printer, a speaker, a microphone, another type of input device, another type of output device, or a combination thereof. As illustrated in FIG. 2, in some embodiments, the HMI 215 includes a display device 270. The display device 270 may be included in the same housing as the user device 110 or may communicate with the user device 110 over one or more wired or wireless connections. For example, in some configurations, the display device 270 is a touchscreen included in a laptop computer or a tablet computer. In other configurations, the display device 270 is a monitor, a television, or a projector coupled to a terminal, desktop computer, or the like via one or more cables.

Returning to FIG. 1, the system 100 may also include the database 115. The database 115 may store system data associated with the industrial system 105. System data may include a set of components 150 included in the industrial system 105 (e.g., the industrial device(s) 152, the industrial process(es) 154 of the industrial system 105, the industrial concept(s) 156, or a combination thereof). Alternatively, or in addition, the system data may include one or more relationships (or set of relationship rules) associated with the industrial system 105 (e.g., the containment relationship(s), the grouping relationship(s), the application-specific relationship(s), other relationship data, or a combination thereof). Alternatively, or in addition, the system data may include one or more modeled capabilities associated with the system model of the industrial system 105. In some embodiments, the system data is accessed (via, e.g., the electronic processor 200 executing the application 260) as part of modeling capabilities within system models of industrial systems, implementing modeled capabilities within the industrial system 105, or the like. Accordingly, the database 115 may store data associated with the system model of the industrial system 105.

As noted above, in some embodiments, two or more components of the system 100 may be combined into a single component. As one non-limiting example, in some embodiments, the database 115 and the user device 110 may be combined, such that the data stored in the database 115 (e.g., the system data) may be stored in the memory 205 of the user device 110.

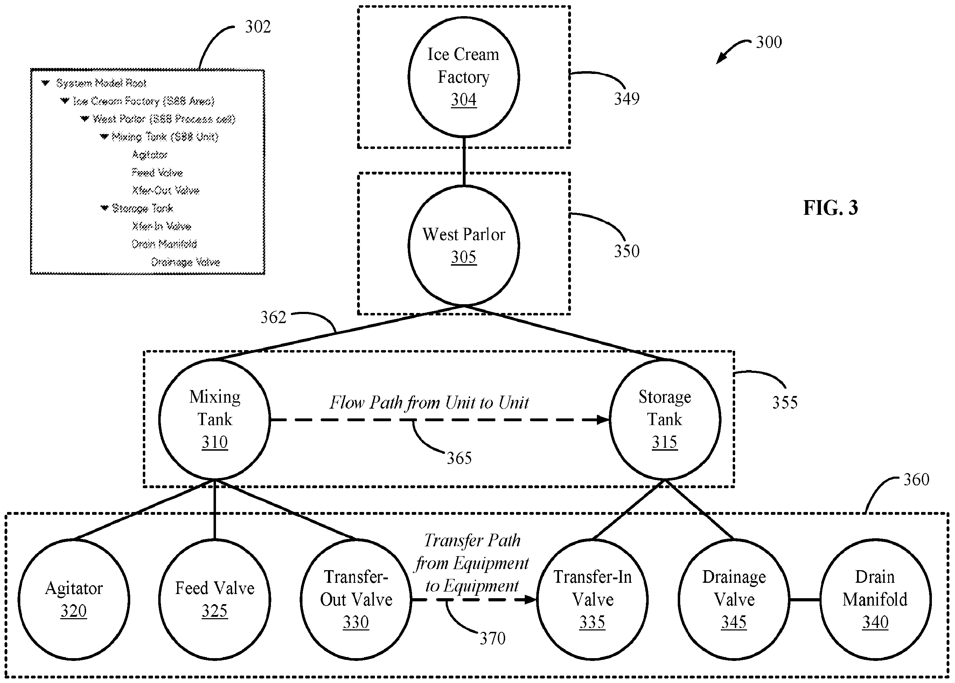

FIG. 3 illustrates an example system model 300 for an industrial system (e.g., the industrial system 105) implemented using batch control according to some embodiments. FIG. 3 also illustrates a hierarchical representation 302 of the system model 300. According to the example of FIG. 3, the system model 300 may include a set of industrial devices (e.g., the industrial device(s) 152). In some instance, an industrial system 105 (including the components 150 therein) are represented as objects (e.g., a set of SmartObjects). As noted herein, "object" may reference an abstract data type representing the industrial system 105 (including the components 150 therein). As illustrated in FIG. 3, the set of objects includes an ice cream factory object 304, a west parlor object 305, a mixing tank object 310, a storage tank object 315, an agitator object 320, a feed valve object 325, a transfer-out valve object 330, a transfer-in valve object 335, a drain manifold object 340, and a drainage valve object 345.

As further illustrated in FIG. 3, the set of objects may be organized into various subsections: an area level 349, a process cell level 350, a unit level 355, and an equipment level 360 (e.g., as part of a batch control capability), where each subsection represents a relationship between the objects. The area level 349 designates an area (e.g., a physical geographical space or region) associated with the industrial system 105 (e.g., an ice cream factory according to the example illustrated in FIG. 3). The process cell level 350 designates a process level associated with the industrial system 105. The unit level 355 designates one or more units associated with the process of the process cell level 350. As illustrated in FIG. 3, the unit level 355 includes the mixing tank object 310 and the storage tank object 315 (as the one or more units). The equipment level 360 designates equipment (e.g., one or more industrial devices 152) of the unit(s) associated with the process of the process cell level 350. As illustrated in FIG. 3, the equipment level 360 includes the agitator object 320, the feed valve object 325, the transfer-out valve object 330, the transfer-in valve object 335, the drain manifold object 340, and the drainage valve object 345.

As illustrated in FIG. 3, the system model 300 may include a set of containment rules (represented by a solid line 362 in FIG. 3). In some embodiments, a containment rule may establish or represent a containment relationship (as described in greater detail herein). As one non-limiting example, the west parlor object 305 has a containment relationship with the mixing tank object 310 and the storage tank object 315. Following this example, the physical mixing tank and the physical storge tank (represented by the mixing tank object 310 and the storage tank object 315, respectively) are contained (or located) in the physical west parlor (represented by the west parlor object 310). As yet another non-limiting example, the mixing tank object 310 has a containment relationship with the agitator object 320, the feed valve object 325, and the transfer-out valve object 330. Following this example, the physical mixing tank (represented by the mixing tank object 310) includes an agitator, a feed valve, and a transfer-out valve (represented by the agitator object 320, the feed valve object 325, and the transfer-out valve object 330, respectively).

Additionally, the system model 300 of FIG. 3 may include one or more special relationships, including flow paths between units and material transfers between equipment phases. A special relationship may include, e.g., a relationship that is not a refinement of a default relationships (e.g., a containment relationship, a grouping relationship, etc.). In the illustrated example of FIG. 3, the system model 300 includes a unit flow path 365 and an equipment transfer path 370 (as special relationships). The unit flow path 365 is between the mixing tank (represented by the mixing tank object 310) and the storage tank (represented by the storage tank object 315). As illustrated, the equipment transfer path 370 is between the transfer-out valve (represented by the transfer-out valve object 330) and the transfer-in valve (represented by the transfer-in valve object 330). The equipment transfer path 370 represents a transfer of material between the transfer-out valve (represented by the transfer-out valve object 330) and the transfer-in valve (represented by the transfer-in valve object 330).

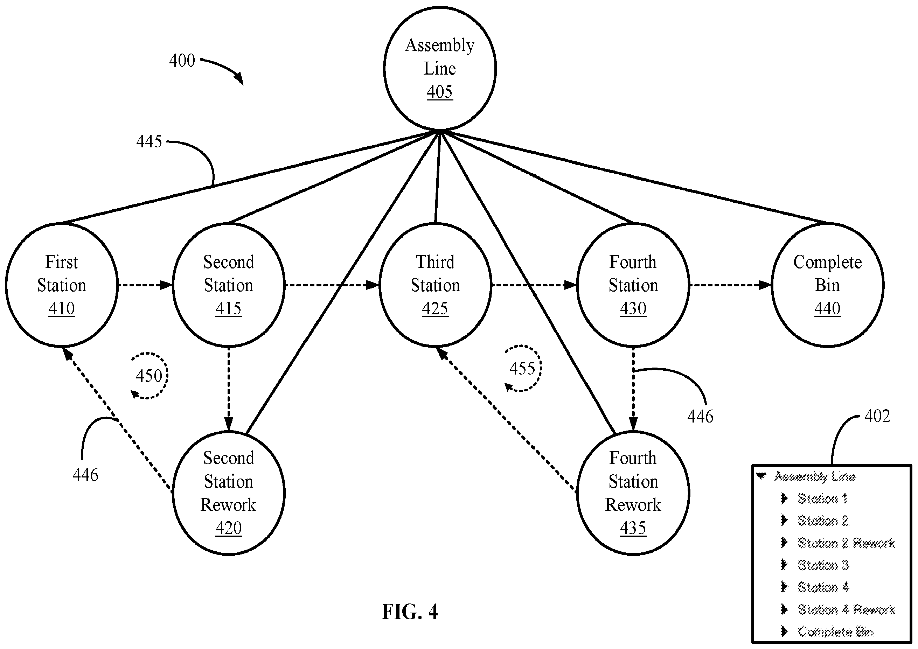

As another example, FIG. 4 illustrates an example system model 400 for an industrial system (e.g., the industrial system 105) implemented using discreate manufacturing routes according to some embodiments. FIG. 4 also illustrates a hierarchical representation 402 of the system model 400. According to the example of FIG. 4, the system model 400 may include a set of objects. In the illustrated example, the objects are associated with industrial components (e.g., one or more of the industrial devices 152) of an industrial system (e.g., the industrial system 105). In some embodiments, one or more of the objects may be autonomous objects. As illustrated in FIG. 4, the set of objects includes an assembly line object 405, a first station object 410, a second station object 415, a second station rework object 420, a third station object 425, a fourth station object 430, a fourth station rework object 435, and a complete bin object 440.

As illustrated in FIG. 4, the system model 400 may include a set of containment rules (represented by a solid line 445 in FIG. 4). As one non-limiting example, the assembly line (represented by the assembly line object 405) has a containment relationship with the first station, the second station, the second station rework, the third station, the fourth station, the fourth station rework, and the complete bin (represented by the first station object 410, the second station object 415, the second station rework object 420, the third station object 425, the fourth station object 430, the fourth station rework object 435, and the complete bin object 440, respectively). Following this example, the assembly line (represented by the assembly line object 405) includes the first station, the second station, the second station rework, the third station, the fourth station, the fourth station rework, and the complete bin (represented by the first station object 410, the second station object 415, the second station rework object 420, the third station object 425, the fourth station object 430, the fourth station rework object 435, and the complete bin object 440, respectively).

Additionally, the system model 400 of FIG. 4 may include one or more special relationships for conditional paths between workstations (represented in FIG. 4 as a dashed line 446). In the illustrated example of FIG. 4, the system model 400 may include a first conditional route path (represented in FIG. 4 by the arrow 450) between the first station object 410, the second station object 415, and the second station rework object 420. As one non-limiting example, the first conditional route path 450 may be followed when a product does not pass a predetermined threshold associated with the second station object 415. Similarly, as another non-limiting example, a second conditional route path (represented in FIG. 4 by the arrow 455) may be followed when a product does not pass a predetermined threshold associated with the fourth station object 430.

Alternatively, or in addition, in some embodiments, a state machine may be configured as an extension capability. As one non-limiting example, highly state-based machine behavior may be configured as a capability. In such embodiments, the system model may include a set of objects (e.g., state objects). Each state may describe its name and one or more actions that the state performs. The set of state objects may have containment rules (as similarly described above with respect to FIGS. 3 and 4). Alternatively, or in addition, the set of state objects may have special relationships, such as for conditional paths between states (as similarly described above with respect to FIGS. 3 and 4). As one non-limiting example, a special relationship may include a custom relationship whose rule defines when a state transition occurs, making its source inactive and the state it points to active (e.g., as a state transition).

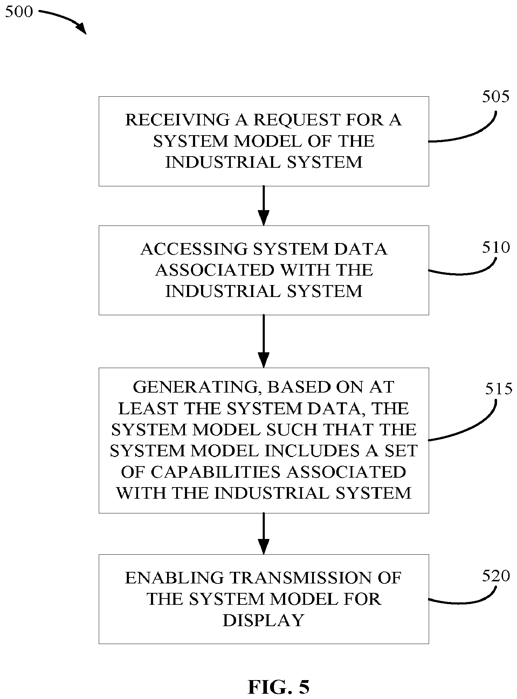

FIG. 5 is a flowchart illustrating an example method 500 for modeling capabilities within system models of industrial systems according to some embodiments. The method 500 is described herein as being performed by the user device 110 (e.g., the electronic processor 200 executing the application 260).

As illustrated in FIG. 5, the method 500 includes receiving, with the electronic processor 200, a request for a system model of the industrial system 105 (at block 505). In some embodiments, the electronic processor 200 receives the request from a user interacting with the user device (via, e.g., the HMI 215). As described in greater detail herein, the system model includes a set of components (e.g., one or more of the components 150) with relationships, where each relationship governs interaction between at least two components included in the set of components.

The electronic processor 200 may then access system data associated with the industrial system 105 (at block 510). As noted above, the system data may be stored remotely in the database 115. Accordingly, in some embodiments, the electronic processor 200 may access the system data from the database 115 (over the communication network 130). Alternatively, or in addition, in some embodiments, the system data may be locally stored in the memory 205 of the user device 110. In such embodiments, the electronic processor 200 may access the system data from the memory 205. As described in greater detail herein, the system data may include a set of components 150 included in the industrial system 105 (e.g., the industrial device(s) 152, the industrial process(es) 154 of the industrial system 105, the industrial concept(s) 156, or a combination thereof), one or more relationships (or set of relationship rules) associated with the industrial system 105 (e.g., the containment relationship(s), the grouping relationship(s), the application-specific relationship(s), other relationship data, or a combination thereof), one or more modeled capabilities associated with the system model of the industrial system 105, or the like.

Based on at least the system data, the electronic processor 200 may generate the system model such that the system model includes a set of capabilities associated with the industrial system 105 (at block 515). As described in greater detail herein, a capability is a set of components and relationships between those components that describe a function or functional portion of the industrial system 105. In some embodiments, the capability is a specialization that exists within a system model.

Alternatively, or in addition, in some embodiments, the electronic processor 200 may receive a user input defining a new capability (e.g., a custom extension to an existing system model). In such embodiments, the user input may indicate a set of components (e.g., a new subset of components 150 of the industrial system 105), a new relationship between those components (e.g., a custom relationship defined by the user, such as a relationship that aligns with an end-user's application or implementation of the industrial system 105), or a combination thereof. In response to receiving the user input, the electronic processor 200 may generate (or re-generate) the system model such that the system model includes the new capability.

After generating the system model (at block 515), the electronic processor 200 may then enable transmission of the system model for display (at block 520). In some embodiments, the electronic processor 200 transmits the system model for display to a user via the HMI 215. When the system model is displayed to the user via the HMI 215, the electronic processor 200 may enable a user to interact with the system model. A user may interact with the system model by viewing the system model. Alternatively, or in addition, the user may interact with the system model by providing user input with respect to the system model (or the industrial system 105).

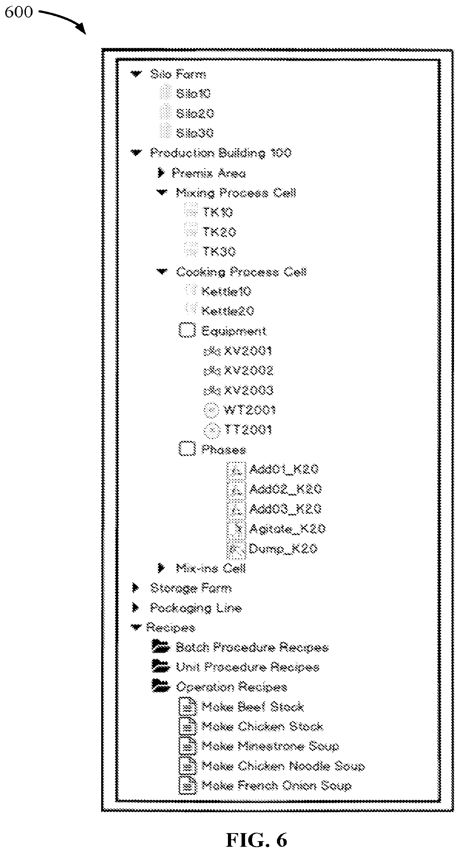

As one non-limiting example, FIG. 6 illustrates an example system model 600 provided to a user (via, e.g., the HMI 215 of the user device 110) according to some embodiments. As illustrated in FIG. 6, in some embodiments, the system model 600 may be provided as a hierarchical representation of the system model 600, where a user may interact with the hierarchical representation by expanding or collapsing one or more portions of the hierarchical representation. Accordingly, in some embodiments, the electronic processor 200 may generate and transmit a hierarchical representation of the system model for display to a user.

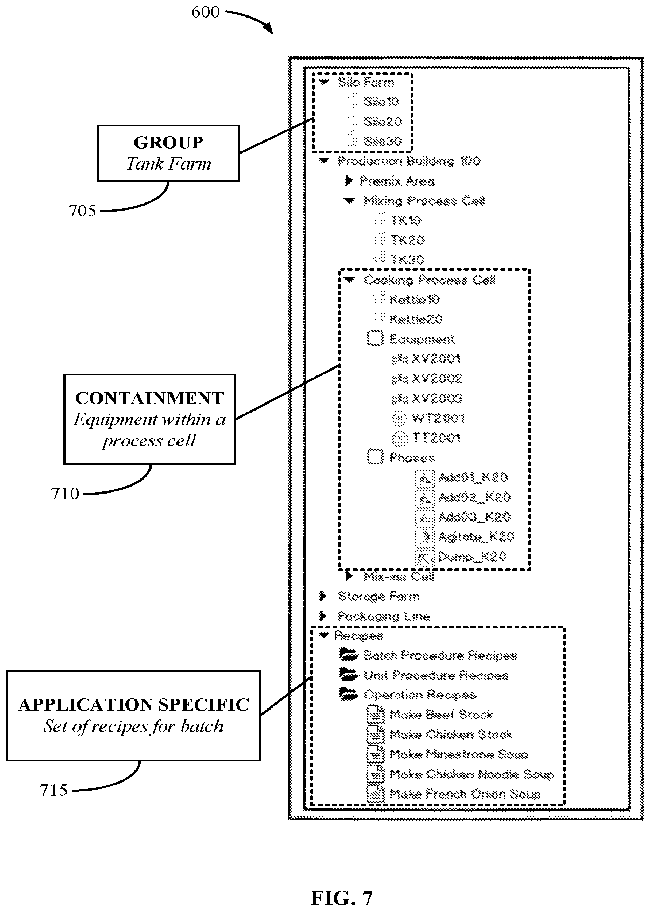

As illustrated in FIG. 7, the system model 600 may include relationships between various components 150 of the industrial system 105. In the illustrated example, the system model 600 includes a group of silos (represented in FIG. 7 by reference numeral 705), as an example grouping relationship. The system model 600 also includes a process cell (represented in FIG. 7 by reference numeral 710), as an example containment relationship. The system model 600 also includes a set of recipes (represented in FIG. 7 by reference numeral 715), as an example application-specific relationship.

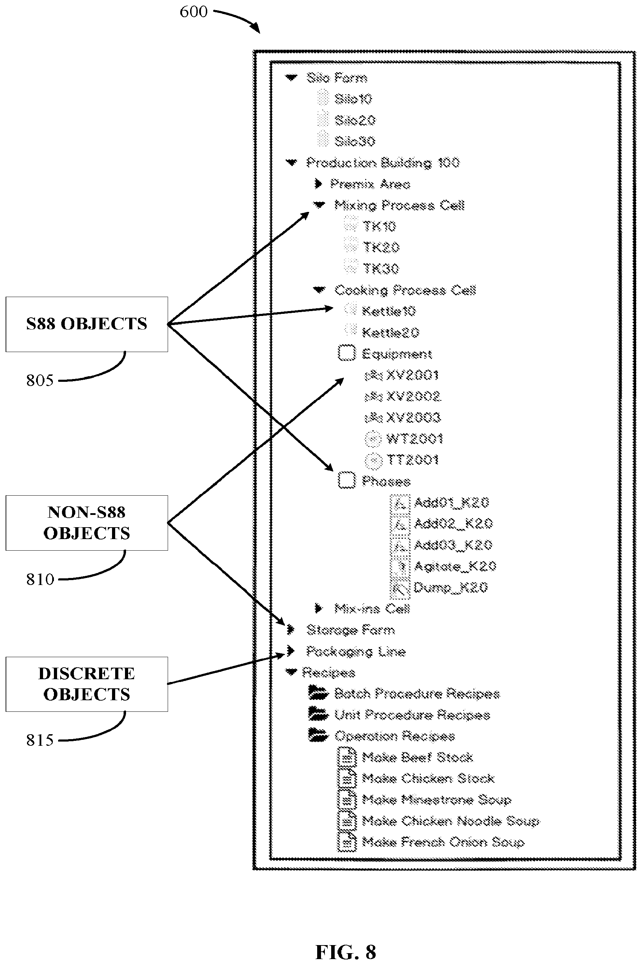

As noted herein, a component 150 of the industrial system 105 may be associated with one or more capabilities. Accordingly, each system model extension may coexist within the same system model without affecting each other. System model extension objects may follow the relationship rules of their capability relative to each other, where objects that are not of the same capability may ignore non-members. As such, an object may implement multiple capabilities. As one non-limiting example, FIG. 8 illustrates the system model 600 according to some embodiments were the system model 600 includes a mixture of S88 standard objects (represented in FIG. 8 by reference numeral 805), non-S88 objects (represented in FIG. 8 by reference numeral 810), and discrete manufacturing objects (represented in FIG. 8 by reference numeral 815). Accordingly, as illustrated by the example of FIG. 8, in some embodiments, a system model (e.g., the system model 600) may include objects associated with different capabilities. For example, as illustrated in the example of FIG. 8, in some embodiments, a system model may include default system model objects, batch control objects, non-batch control objects, and discrete objects. In the illustrated example, the system model 600 validates such that relative to each other, the S88 objects 805 follow the S88 rules (e.g., relationship rule associated with S88, such as batch control relationships defined as part of the S88 standard for batch control). Objects that are not of the S88 capability (e.g., the non-S88 objects 810 and the discrete objects 815) follow the general validation rules for all objects. Accordingly, an object may be a member of more than one capability and will validate so long as it follows the rules (e.g., the relationship rules) of each capacity that the object belongs.

Alternatively, or in addition, in some embodiments, the electronic processor 200 may enable implementation of one or more capabilities within the industrial system 105. In some embodiments, the electronic processor may implement a capability within the industrial system 105 by configuring one or more components 150 associated with the at least one capability such that the one or more components 150 interact according to at least one relationship associated with the at least one capability to perform a function associated with the at least one capability. In some embodiments, the electronic processor 200 implements one or more capabilities as part of the system metadata of the system model. Thus, the electronic processor 200 may check the configuration for correctness and consistency using the system metadata. The existence of the system metadata enables abilities such as checking configurations as they are entered, type ahead and automatic filling in of data, identifying undefined objects and relationships, and the like.

What has been described above includes examples of the disclosed technology. It is, of course, not possible to describe every conceivable combination of components or methodologies for purposes of describing the disclosed technology, but one of ordinary skill in the art may recognize that many further combinations and permutations of the disclosed technology are possible. Accordingly, the disclosed technology is intended to embrace all such alterations, modifications, and variations that fall within the spirit and scope of the appended claims.

In particular and in regard to the various functions performed by the above described components, devices, circuits, systems and the like, the terms (including a reference to a "means") used to describe such components are intended to correspond, unless otherwise indicated, to any component which performs the specified function of the described component (e.g., a functional equivalent), even though not structurally equivalent to the disclosed structure, which performs the function in the herein illustrated exemplary aspects of the disclosed technology. In this regard, it will also be recognized that the disclosed technology includes a system as well as a computer-readable medium having computer-executable instructions for performing the acts and/or events of the various methods of the invention.

In addition, while a particular feature of the disclosed technology may have been disclosed with respect to only one of several implementations, such feature may be combined with one or more other features of the other implementations as may be desired and advantageous for any given or particular application. Furthermore, to the extent that the terms "includes," and "including" and variants thereof are used in either the detailed description or the claims, these terms are intended to be inclusive in a manner similar to the term "comprising."

## Claims

1. A system for modeling capabilities within system models of industrial systems, the system comprising:
an electronic processor configured to
receive a request for a system model of an industrial system associated with a set of components,
access system data associated with the industrial system,
generate, based on at least the system data, a system model such that the system model includes a set of capabilities associated with the industrial system, wherein each capability included in the set of capabilities is associated with a function of the industrial system, and
enable transmission of the system model for display.

2. The system of claim 1, wherein the system model includes a set of components with relationships, wherein each relationship governs interaction between at least two components included in the set of components.

3. The system of claim 1 or 2, wherein each capability includes a subset of components included in the set of components and at least one relationship between at least two components included in the subset of components.

4. The system of claim 3, at least one of:
wherein the at least one relationship governs interaction between the at least two components; and
wherein the at least one relationship is a custom relationship defined by an end-user based on an application of the industrial system.

5. The system of one of claims 1 to 4, wherein the set of components includes a first component and a second component, wherein the first component is associated with a first capability of the set of capabilities and the second component is associated with a second capability of the set of capabilities, wherein the first capability is different from the second capability.

6. The system of one of claims 1 to 5, wherein the electronic processor is further configured to
receive a user input defining a new capability, the user input indicating a custom relationship between two or more components included in the set of components, wherein the system model includes the new capability.

7. The system of claim 6, wherein the user input indicates a new subset of components, the new subset of components including the two or more components.

8. The system of one of claims 1 to 7, wherein the electronic processor is further configured to enable implementation of the at least one capability via the industrial system.

9. The system of claim 8, wherein the electronic processor is further configured to enable implementation of the at least one capability by configuring one or more components associated with the at least one capability such that the one or more components interact according to at least one relationship associated with the at least one capability to perform a function associated with the at least one capability.

10. The system of one of claims 1 to 9, at least one of:
wherein the data associated with the industrial system includes a set of components, wherein the set of components includes at least one selected from a group consisting of a device associated with the industrial system, a state associated with the industrial system, and a process associated with the industrial system; and
wherein the electronic processor is further configured to generate a hierarchical representation of the system model for display.

11. A method for modeling capabilities within system models of industrial systems, the method comprising:
receiving, with an electronic processor, a request for a system model of an industrial system associated with a set of components;
accessing, with the electronic processor, system data associated with the industrial system;
generating, with the electronic processor, based on at least the system data, a system model such that the system model includes a set of capabilities associated with the industrial system, wherein each capability included in the set of capabilities is associated with a function of the industrial system; and
enabling, with the electronic processor, transmission of the system model for display.

12. The method of claim 11, further comprising:
receiving a user input defining a new capability, the user input indicating a custom relationship between two or more components included in the set of components,
wherein generating the system model includes generating the system model based at least in part on the new capability.

13. The method of claim 11 or 12, at least one of:
wherein generating the system model includes generating the system model such that each capability includes a subset of components included in the set of components and at least one relationship between at least two components included in the subset of components, wherein the at least one relationship is a custom relationship defined by an end-user based on an application of the industrial system; and
wherein generating the system model includes generating a system model that includes a set of components including a first component and a second component, wherein the first component is associated with a first capability of the set of capabilities and the second component is associated with a second capability of the set of capabilities, wherein the first capability is different from the second capability.

14. A non-transitory computer-readable medium storing instructions that, when executed by an electronic processor, perform a set of functions, the set of functions comprising:
receiving a request for a system model of an industrial system associated with a set of components;
accessing system data associated with the industrial system;
generating based on at least the system data, a system model such that the system model includes a set of capabilities associated with the industrial system, wherein each capability included in the set of capabilities is associated with a function of the industrial system; and
enabling transmission of the system model for display.

15. The computer-readable medium of claim 14, at least one of:
wherein the set of functions further include:
receiving a user input defining a new capability, the user input indicating a custom relationship between two or more components included in the set of components,
wherein generating the system model includes generating the system model based at least in part on the new capability;
wherein the set of functions further include:
enabling implementation of the at least one capability by configuring one or more components associated with the at least one capability such that the one or more components interact according to at least one relationship associated with the at least one capability to perform a function associated with the at least one capability; and
wherein the set of functions further include:
generating a hierarchical representation of the system model for display.
